# FASCICULE DE BREVET EUROPEEN

(11) **EP 0 684 653 B1**
(45) Date de publication et mention de la délivrance du brevet: **07.01.1999**
(21) Numéro de dépôt: 95400938.7
(22) Date de dépôt: 26.04.1995
(51) Int. Cl.: H01L 31/102, H01L 31/101, H03B 7/14, H03B 9/14, H01L 47/02

(54) **Composant à hétérostructure semi-conductrice, commandé par la lumière pour la génération d'oscillations hyperfréquences**
Lichtgesteuerter Heterostruktur-Halbleiterbaustein zur Erzeugung von Mikrowellen
Light-controlled heterostructure semiconductor device for generating microwaves

(30) Priorité: 28.04.1994 FR 9405157
(43) Date de publication de la demande: 29.11.1995
(73) Titulaire: FRANCE TELECOM, 75015 Paris (FR)
(72) Inventeur: Le Person, Henri, F-94110 Arcueil (FR); Minot, Christophe, F-75015 Paris (FR); Palmier, Jean-François, F-92260 Fontenay aux Roses (FR)
(74) Mandataire: Texier, Christian

(56) Documents cités:
- FR-A- 1 521 132
- APPLIED PHYSICS LETTERS., vol.25, no.9, 1 Novembre 1974, NEW YORK US pages 493 - 495 S.Y.WANG ET AL. 'Enhanced optical frequency detection with negative differential resistance in metal-barrier-metal point contact diodes'
- PATENT ABSTRACTS OF JAPAN vol. 9, no. 10 (E-290) (1733) 17 Janvier 1985 & JP-A-59 161 083 (YOKOGAWA HIYUURETSUTO PATSUKAADO KK) 11 Septembre 1984
- GEC JOURNAL OF RESEARCH (INCORPORATING MARCONI.REVIEW.), vol.4, no.3, 1986, GREAT BADDOW CHEMSFORD GB D.G.PARKER ET AL. 'Photoreceivers for microwave and millimetre wave applications'

## Description

La présente invention concerne le domaine des composants à hétérostructures semi-conductrices, commandés par la lumière pour la génération d'oscillations hyperfréquences.

La présente invention peut trouver application en particulier, mais non exclusivement, dans la réalisation de composants actifs pour la conversion de fréquences optiques en hyperfréquences, de générateurs hyperfréquences à commande optique, de détecteurs ultra-rapides de signaux optiques faibles et de générateurs de trains , pour en particulier les radars, les réseaux d'antennes, les antennes à balayage.

On a déjà proposé différentes structures de composants semiconducteurs commandés optiquement et notamment : 1) des diodes à effet Gunn ou à transfert de charge, dénommées généralement ``TED'' (pour l'expression anglaise Transferred-Electron Devices), 2) des diodes dites IMPATT (pour l'expression anglaise Impact Ionization avalanche Transit Time), 3) des transistors à effet de champ dénommés généralement "FET"(pour l'expression anglaise Field Effect Transistor) et 4) des transistors à haute mobilité électronique dénommés généralement ``HEMT'' (pour l'expression anglaise High Electron Mobility Transistor).

Pour les diodes à effet Gunn ou à transfert de charge commandées optiquement on peut se référer par exemple au document T.F. Carruthers, J.F. Weller, H.F. Taylor et T.G. Mills, Applied Physics Letters **38** (4), 15 Février 1981, pp. 202-204, titre de la publication : "Oscillation Burst Generation in Transferred-Electron Devices with Picosecond Optical Pulses".

Pour les diodes dites IMPATT, on peut se référer par exemple au document A.J.Seeds, J.F. Singleton, S.P. Brunt et J.R. Forest, Journal of Lightwave Technology, vol.LT-5, pp. 403-411, 1987, titre de la publication : "The Optical Control of IMPATT Oscillators".

Pour les transistors à effet de champ et les transistors à haute mobilité électronique, on peut se référer par exemple au document R.N. Simons, IEEE Transactions on Microwave Theory and Techniques, vol. MTT-35, pp. 1444-1455, Dec. 1987, titre de la publication : "Microwave Performance of an Optically Controlled AlGaAs/GaAs High Electron Mobility Transistor and GaAs MESFET''.

Les structures mentionnées ci-dessus ont déjà donné des résultats sensibles.

Cependant ces structures connues ne donnent pas totalement satisfaction.

En particulier on peut noter que ces structures connues :
- présentent une faible sensibilité ou exigent une technologie complexe,
- présentent un courant d'obscurité non négligeable,
- ne permettent pas d'optimiser le coefficient d'absorption du matériau en fonction de la longueur d'onde excitatrice.

La présente invention a maintenant pour but de perfectionner les composants à hétérostructures semi-conductrices, commandés par la lumière pour la génération d'oscillations hyperfréquences.

Plus précisément des buts importants de la présente invention sont les suivants :
- Ajuster le domaine spectral de sensibilité à l'excitation optique, particulièrement aux longueurs d'onde 1,3 et 1,5 micron utilisées généralement pour les communications optiques,
- Augmenter la sensibilité du composant à la commande optique et avoir un bon rendement,
- Augmenter la fréquence maximale générée,
- simplifier la fonction oscillateur commandé optiquement et la rendre intégrable avec les composants électroniques et optoélectroniques utilisés pour les télécommunications.

Ces buts sont atteints dans le cadre de la présente invention grâce à un composant à hétérostructure semi-conductrice, commandé par la lumière pour la génération d'oscillations hyperfréquences, tel que défini en revendication 1.

Comme on l'explicitera par la suite la dissociation du rôle d'absorbant lumineux de celui d'oscillateur, définie dans le cadre de la présente invention, permet d'améliorer les performances des composants semi-conducteurs, commandés par la lumière pour la génération d'oscillations hyperfréquences.

D'autres caractéristiques, buts et avantages de la présente invention apparaitront à la lecture de la description détaillée qui va suivre et en regard des dessins annexés, donnés à titre d'exemple non limitatif et sur lesquels :
- la figure 1 représente une vue en coupe d'une structure de composant conforme à la présente invention et
- les figures 2 et 3 représentent respectivement les réponses obtenues sur une structure conforme à la présente invention pour deux niveaux d'énergie optique appliquée.

Comme on l'a indiqué précédemment le composant conforme à la présente invention comprend une hétérostructure formée d'au moins deux matériaux semi-conducteurs 10, 20.

Le premier matériau 10 assure la fonction minimale d'absorbant de la lumière. Il constitue également une zone où transitent rapidement les porteurs minoritaires photocréés qui induisent un fort courant de majoritaires venant de la cathode.

Le second matériau 20 possède, pour les porteurs majoritaires, une loi de vitesse en fonction du champ électrique qui présente une région à pente négative (vitesse différentielle négative). De préférence ce second matériau 20 est également choisi de sorte que les porteurs minoritaires y soient plus lents que dans le premier matériau 10 ou que l'hétérojonction (entre les matériaux 10 et 20) soit bloquante pour les porteurs minoritaires.

Par ailleurs l'hétérojonction joue le rôle d'une zone d'accumulation des charges minoritaires ce qui a pour effet d'augmenter l'amplitude des oscillations et le gain.

Selon un mode de réalisation préférentiel qui sera précisé par la suite, le premier matériau 10 est constitué d'une couche massive en GaAs, tandis que le second matériau 20 est constitué d'un super-réseau GaAs/AlAs.

On sait qu'un super-réseau est constitué d'une succession de puits de potentiel séparés par des barrières très fines et couplés par effet tunnel résonant. Les super-réseaux ont déjà donné lieu à une littérature abondante.

L'utilisation d'un semi-conducteur en GaAs pour former le premier matériau 10 permet d'obtenir une structure absorbante dans la région du visible au proche infrarouge, soit 0,4 à 0,85 µm. Cependant la présente invention n'est pas limitée à l'utilisation de ce matériau particulier pour former le premier matériau 10. Elle peut s'étendre à d'autres matériaux, y compris des super-réseaux, ayant une plage spectrale d'absorption différente et notamment à 1,3 et 1,5 µm. Ainsi, à titre d'exemple non limitatif, dans le cas des applications utilisant la plage des longueurs d'onde optique allant de 1,3 à 1,55µm, il est possible d'employer comme matériaux optiquement absorbant pour la couche 10, les matériaux suivants :
a) des matériaux massifs comme In_{0.53}Ga_{0.47}As ou plus généralement InₓGa₁₋ₓAs_{y}P_{1-y} avec x≅0.47y et 0.737≦y≦1 et, en conséquence de quoi les valeurs prises par x doivent être comprises entre 0.346 et 0.47 (InGaAs). Les valeurs du gap de InGaAsP étant alors comprises entre 0.86 eV(λ=1.55µm) et 0.724 eV (valeur du gap de InGaAs).
   On peut aussi utiliser AlₓGa_{y}In_{1-x-y}As avec 0≤x≤0.165 et 0.468≥y≥0.306.
b) des super-réseaux en matériaux ternaires comme GaInAs/AlInAs ou en quaternaires comme GaInAsP/AlGaInAs.

Tous ces matériaux ci-dessus énumérés sont susceptibles de croître sur InP : cela signifie que le matériau épitaxié (InGaAs, InAIAs, etc...) et le substrat (InP) sont en accord de maille.

Cependant les matériaux qui ne sont pas en accord de maille (pseudo-morphiques : matériaux contraints) peuvent être aussi utilisés.

La liste ci-dessus n'est pas exhaustive, on peut en effet utiliser dans le cadre de l'invention, d'autres composés réalisés à partir des matériaux III-V comme InSb, GaSb etc ... ou de matériaux II-VI ou même des super-réseaux élaborés à partir du couple SiGe/Si.

L'utilisation d'un super-réseau pour former le second matériau 20, permet d'obtenir une loi de vitesse à pente négative sur une plage importante de la valeur du champ électrique appliqué, pour les électrons. Et l'existence de cette loi de vitesse pour les majoritaires permet d'engendrer des oscillations de courant et donc la formation de domaines de majoritaires transitant dans la structure de façon similaire à l'effet Gunn- sans nécessairement utiliser un circuit résonant comme pour les diodes IMPATT.

D'autre part le choix d'un second matériau 20 de sorte que les porteurs minoritaires y soient plus lents que dans le premier matériau 10, contribue à allonger la durée du train des oscillations.

La présente invention n'est pas limitée à un super-réseau GaAs/AlAs pour former le second matériau 20, mais peut s'étendre à tous les semi-conducteurs à vitesse différentielle négative, y compris des matériaux massifs.

Par exemple pour une couche absorbante 10 formée d'un super-réseau GaInAs/AlInAs ou GaInAsP/AlGaInAs, la couche 20 peut être constituée d'un super-réseau en GaInAs/AlInAs ou GaInAsP/AlGaInAs, l'ensemble devant respecter la condition d'hétérostructure (choix adéquat des différents lois de vitesse des porteurs).

Les matériaux contenant de l'In (indium) et du P (phosphore) sont épitaxiés sur InP et non sur GaAs.

Si la couche absorbante 10 est en GaAs, l'autre couche 20 est donc de préférence soit en GaAlAs, AlAs, soit un super-réseau en GaAs/AlAs ou GaAs/GaAlAs. Le substrat (matériau sur lequel la croissance est réalisée) est alors en GaAs.

Pour les applications en télécommunications, on utilise plus généralement un substrat en InP, le matériau 10 est alors avantageusement en InGaAs et le second matériau 20 est alors constitué soit d'un matériau massif soit d'un super-réseau (InGaAs/InAlAs ou InGaAsP/InAlAsP).

Bien entendu les matériaux 10 et 20 doivent être choisis pour satisfaire la condition hétérostructure, c'est à dire que ces matériaux doivent présenter des intervalles de bande interdite différents à moins qu'ils ne soient séparés par un troisième matériau ou empilement de matériaux, permettant de satisfaire cette condition.

La structure de base conforme à la présente invention comprenant les deux matériaux 10 et 20 précités permet d'associer un premier matériau "gachette" 10 où les porteurs sont rapides, donc à effets de transport peu limitatifs en fréquence, à un second matériau 20 (formé par exemple d'un super-réseau) offrant un grand choix de lois de vitesse.

L'avantage d'une telle structure est d'avoir un milieu à vitesse différentielle négative peu épais, donc pouvant fonctionner à des fréquences élevées, commandé via un mécanisme rapide de génération et d'accumulation de minoritaires. Il faut noter que dans une telle association, la capacité parasite effective est celle des deux matériaux 10 et 20 en série.

De plus comme on l'a mentionné précédemment, la persistance des oscillations est également due au fait qu'à l'hétérojonction se crée une couche d'accumulation de porteurs minoritaires en raison de la différence des vitesses de ces derniers dans les deux matériaux.

Les super-réseaux offrent différents avantages par rapport aux autres matériaux en volume ayant aussi une vitesse différentielle négative. Tout d'abord en raison de leur double périodicité et de l'existence de minibandes, ces super-réseaux offrent un très large éventail de lois de vitesse dépendant du champ électrique tant pour les électrons, qui nécessitent une loi de vitesse en fonction du champ électrique à pente négative, que pour les trous. Ces derniers, rappelons-le, contrôlent la durée du train des oscillations. De plus les super-réseaux offrent la possibilité d'adapter la valeur de l'intervalle de bande interdite, en jouant sur les paramètres des super-réseaux : puits, barrière, et par conséquent le coefficient d'absorption à une longueur d'onde, mais aussi dans une certaine mesure, le type de l'hétérojonction.

On va maintenant décrire un mode de réalisation particulier et non limitatif de la présente invention.

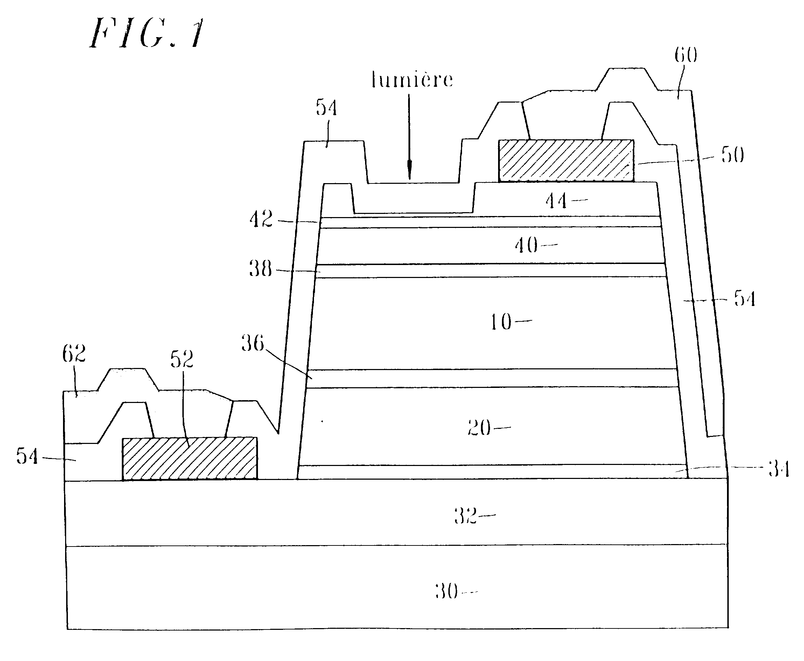

Ce mode de réalisation particulier est obtenu, comme on le voit sur la figure 1, par croissance épitaxiale en phase gazeuse sur un substrat 30 en GaAs semi-isolant, des différentes couches suivantes (et dans l'ordre indiqué ci-dessous) :
- une couche 32 de GaAs de 0,84 µm d'épaisseur, dopé, servant à la prise de contact;
- une couche graduelle dopée 34, qui est constituée comme toutes les couches graduelles d'un super-réseau GaAs/AlAs de période variable;
- un super-réseau en GaAs/AlAs, non dopé, de 53 périodes de 14 monocouches de GaAs et de 6 monocouches de AlAs, qui constitue le second matériau 20;
- une couche graduelle non dopée 36;
- une couche massive de GaAs de 0,9 µm d'épaisseur, non dopée, qui constitue le premier matériau 10;
- une couche graduelle dopée 38;
- une couche 40 dite "fenêtre" transparente à la longueur d'onde excitatrice, dopée, qui est constituée de 100 périodes d'un super-réseau GaAs/AlAs de respectivement 3 monocouches de GaAs et de 4 monocouches de AlAs;
- une couche graduelle dopée 42 et finalement
- une couche 44 de GaAs dopé de 0,2 µm d'épaisseur.

Les épaisseurs des couches précédemment énumérées le sont à titre d'exemple de réalisation et ne sont pas critiques.

La couche supérieure 44 sert de façon comparable à la couche inférieure 32, de prise de contact.

Toutes les couches dopées sont de type n, donneur silicium, et suffisamment dopées pour que la valeur des résistances d'accès soit négligeable. Pour le GaAs le dopage est supérieur à 3.10¹⁸ cm⁻³.

Après croissance, les couches 44, 42, 40, 38, 10, 36, 20 et 34 de la structure ainsi formée sont gravées en pavé ou ruban, pour dégager la couche 32, comme on le voit sur la figure 1.

Des contacts ohmiques 50, 52 sont déposés respectivement sur la couche supérieure 44 de la structure et sur la couche de base 32 dégagée.

Puis une couche d'isolant 54 est déposée sur l'ensemble du composant. L'isolant 54 doit être optiquement transparent à la longueur d'onde de travail. L'isolant 54 utilisé est avantageusement de la silice, car la silice n'induit aucune contrainte dans les matériaux sur lesquels elle est déposée. De plus, sont épaisseur peut être ajustée pour qu'elle constitue en plus une couche antireflet pour la longueur d'onde optique excitatrice. Cependant avant de déposer la couche d'isolant 54, la couche supérieure 44 est localement gravée sur une partie de son épaisseur, comme on le voit sur la figure 1, en regard du lieu d'application de la lumière d'excitation, de sorte que cette couche supérieure 44 laisse passer la lumière vers la couche absorbante 10.

Enfin des passages sont ouverts dans cette couche d'isolant 54 à la verticale des contacts ohmiques 50, 52 pour permettre la réalisation de prises de contact électrique sur les contact ohmiques 50, 52 grâce à des métallisations 60, 62 par exemple à base d'or.

Avec la structure décrite précédemment, la borne de polarisation positive doit être reliée à la métallisation 60.

La couche 40 formant fenêtre n'est pas absolument indispensable, elle permet cependant une bonne répartition du potentiel sur la surface de la couche absorbante 10, malgré la localisation du contact ohmique 50.

La structure ainsi obtenue permet sous excitation optique et polarisation de la structure grâce aux métallisations 60, 62, l'obtention d'oscillations de fréquences centrales variant de 28 à 18 GHz pour des tensions de polarisation allant respectivement de 4 à 8 Volts. La durée du train des oscillations est supérieure à 200 ps. L'énergie optique de commande est d'environ 45 femto-Joule par impulsion.

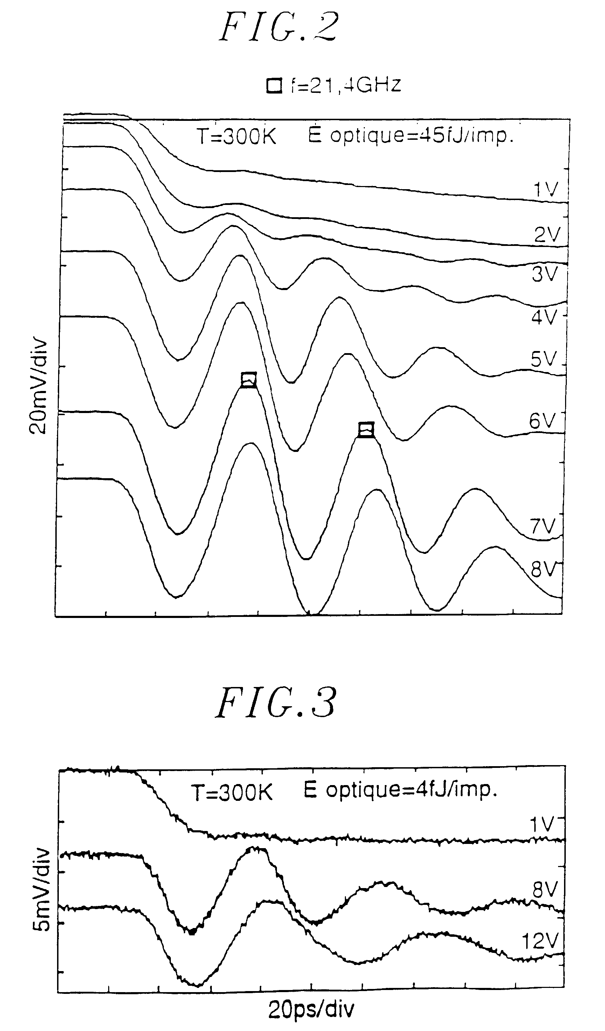

Plus précisément la figure 2 représente la réponse de la structure sous une énergie de commande de 45 fJ par impulsion, tandis que la figure 3 représente la réponse de la structure sous une énergie de commande de 4 fJ par impulsion. Il faut noter que sur les figures 2 et 3 les différentes courbes de réponse correspondant à des tensions de polarisation différentes ont été décalées pour faciliter la lecture; cependant en pratique toutes ces courbes correspondent à des courants d'obscurité très faibles.

En pratique on peut réaliser simultanément de nombreux composants conformes à la présente invention sur une plaquette commune. Après individualisation de chaque composant, celui-ci est collé et connecté à une ligne à micro-ruban ayant une bande passante supérieure à la fréquence de fonctionnement désirée. On obtient alors un composant hybride.

Cependant, pour les fréquences très élevées (supérieures à 50GHz) on peut avoir avantage à intégrer l'ensemble (composant et ligne à micro-ruban) dans un seul processus technologique.

La structure du composant peut être étudiée pour présenter une fréquence de fonctionnement spécifique, en définissant cette structure à l'aide d'une simulation numérique du fonctionnement du composant ou en variante très approximativement en déterminant le rapport entre la demi-valeur de la vitesse maximale des électrons dans le second matériau 20 pour une tension de polarisation optimale, par exemple d'environ 8 Volts, et l'épaisseur de ce second matériau 20. La simulation numérique précitée fait intervenir essentiellement la loi de vitesse des porteurs dans les matériaux considérés.

Bien entendu la présente invention n'est pas limitée au mode de réalisation particulier qui vient d'être décrit, mais s'étend à toutes variantes conformes à son esprit.

Par exemple pour augmenter l'efficacité de conversion optique/hyperfréquences et la durée des oscillations, on peut doper le super réseau 20 et la couche optiquement absorbante 10 en GaAs à l'aide de donneurs à environ 2.10¹⁶ cm⁻³.

Par ailleurs, dans le cadre de la présente invention, on peut aussi utiliser des structures simplifiées au niveau de la croissance en supprimant certaines au moins des gradualités formées par les couches 34, 36, 38 et 42, sans trop dégrader le rendement et/ou en inversant dans l'ordre de croissance le super-réseau 20 et la couche absorbante 10. Dans ce dernier cas, la couche absorbante 10 est déposée avant le super-réseau 20. De plus dans ce dernier cas, on peut se passer de la couche fenêtre 40 mais une détermination des propriétés optiques des différentes couches est nécessaire. Bien sur le super-réseau 20 doit alors être au moins optiquement transparent à la longueur d'onde de travail, de sorte que la lumière d'excitation puisse parvenir à la couche absorbante 10. Il est également nécessaire dans ce cas d'inverser la polarité de l'alimentation électrique appliquée entre les bornes 60 et 62.

En conclusion la présente invention a permis de réaliser un générateur de trains d'oscillations de grande amplitude à une fréquence centrale variable (de 15 à 40 GHz) dépendant de la tension de polarisation appliquée entre les métallisations 60 et 62 (polarité positive sur le contact 60), et de la commande optique. Cette génération hyperfréquences est déclenchée par une impulsion laser de faible énergie (pouvant atteindre par exemple 4 fJ).

La dissociation du rôle d'absorbant lumineux de celui d'oscillateur permet à la fois d'améliorer le rendement et de choisir la fréquence d'oscillation désirée.

Par ailleurs des simulations numériques ont montré qu'il est possible d'obtenir, grâce à la structure conforme à la présente invention, des oscillations de très bon rendement (comparable aux meilleurs composants existants) à des fréquences largement supérieures à 40 GHz, par exemple supérieures à plusieurs centaines de GHz, et durant des temps de plusieurs nanosecondes.

Selon encore une autre variante on peut prévoir de disposer le contact ohmique 52 sur la surface du substrat 30 opposée au super-réseau 20. Dans ce cas le substrat 30 doit être dopé et peut être confondu avec la couche 32.

A titre d'exemple non limitatif, on peut considérer les références suivantes qui mentionnent les lois de vitesse des porteurs (électrons) tant dans les matériaux massifs comme GaAs, InGaAs etc ..., que dans les structures à super-réseaux.
a) Pour les matériaux massifs :
   GaAs :
   - B.K. Ridley, T.B. Watkins, Proc. Phys. Soc. London 78, 293 (1961).
   - B.K. Ridley, Proc. Phys. Soc. London 82, 954 (1963).
   - C. Hilsum, Proc. IRE 50, 185 (1962).
   - J.B. Gunn, Solid State Comm. 1, 88 (1963).
   InP :
   - J.B. Gunn, Solid State Comm. 1, 88 (1963).
   In_{0.53}Ga_{0.47}As :
   - M.A. Littlejohn, T.H. Glisson, J.R. Hauser [in GalnAsP alloy Semiconductor Ed. T.P. Pearsall (John Wiley, 1982) ch. 10 p.243-74].
   In_{0.52}Al_{0.48}As :
   - H.S. Kim, H. Tian, K.W. Kim, M.A. Littlejohn [Appl. Phys. Lett. (USA) vol. 61 (1992) p.1202-4].
b) Pour les super-réseaux :
   - L. Esabki and R. Tsu, "Superlatrice and negative conductivity in semiconductors", IBM Res. Note, RC-2418, Mar. 1969.
   - A. Sibille, J.F. Palmier, H. Wang and F. Mollot, Phys. Rev. Lett., 64, 52 (1990).
   - H. Le Person, J.F. Palmier, C. Minot, J.C. Esnault and F. Mollot, Surface Science, 228, 441 (1990).
   - C. Minot, H. Le Person, J.F. Palmier and F. Mollot, Phys. Rev. B47, 10024 (1993).
   - A.A. Ignatov, K.F. Renk and E.P. Dodin, Phys. Rev. Lett. 70, 1996 (1993).
   - H.T. Grahn, K. von Klitzing and K. Ploog, G.H. Döhler, Phys. Rev. B43, 12094 (1991).
   - F. Beltram, F. Capasso, D.L. Sivco, A.L. Hutchinson, S.-N. G. Chu and A.Y. Cho, Phys. Rev. Lett. 64, 3167 (1990).

Selon une autre variante, le composant peut être réalisé à partir d'un substrat dopé et en déposant une couche dopée servant de "buffer" (couche de même nature que le substrat mais de grande qualité cristalline, et permettant aux autres couches de croître sans contrainte), avant de déposer les couches 32 à 44 précitées en regard de la figure 1. La prise de contact s'effectue dans ce cas de préférence en disposant le contact ohmique 52 sur la surface du substrat opposée au super-réseau 20.

On peut procéder en outre à l'intégration de tout autre composant (transistor ...) sur le même substrat pour, par exemples, assurer un contrôle découplé de la tension de commande ou amplifier éventuellement.

## Revendications

1. Composant à hétérostructure semi-conductrice, commandé par la lumière pour la génération d'oscillations hyperfréquences, caractérisé par le fait que l'hétérostructure comprend deux contacts électriquement conducteurs (50, 52) et entre ceux-ci au moins deux matériaux semi-conducteurs : l'un (10) au moins optiquement absorbant par création de aires électron-trou, et l'autre (20) ayant pour les porteurs majoritaires injectés par la cathode une loi de vitesse en fonction du champ électrique présentant une région à pente négative.

2. Composant selon la revendication 1, caractérisé par le fait que le premier matériau (10) constitue également une zone où transitent rapidement les porteurs minoritaires photocréés qui induisent un fort courant de majoritaires venant de la cathode.

3. Composant selon l'une des revendications 1 ou 2, caractérisé par le fait que le second matériau (20) est également choisi de sorte que les porteurs minoritaires y soient plus lents que dans le premier matériau (10) ou que l'hétérojonction entre lesdits matériaux (10-20) soit bloquante pour les porteurs minoritaires.

4. Composant selon l'une des revendications 1 à 3, caractérisé par le fait que le premier matériau (10) est constitué d'une couche massive.

5. Composant selon l'une des revendications 1 à 4, caractérisé par le fait que le premier matériau (10) est constitué d'une couche massive en GaAs.

6. Composant selon l'une des revendications 1 à 4, caractérisé par le fait que le premier matériau (10) est constitué d'une couche massive en InₓGa₁₋ₓAs_{y}P_{1-y} ou In_{0,53}Ga_{0,47}As ou AlₓGa_{y}In_{1-x-y}As.

7. Composant selon l'une des revendications 1 à 3, caractérisé par le fait que le premier matériau (10) est constitué d'un super-réseau.

8. Composant selon la revendication 7, caractérisé par le fait que le premier matériau (10) est constitué d'un super-réseau en GalnAs/AlInAs ou GalnAsP/AlGalnAs.

9. Composant selon l'une des revendications 1 à caractérisé par le fait que le second matériau (20) est constitué d'un super-réseau.

10. Composant selon l'une des revendications 1 à 7, caractérisé par le fait quc le second matériau (20) est constitué d'un super-réseau GaAs/AlAs.

11. Composant selon l'une des revendications 1 à 7, caractérisé par le fait que le second matériau (20) est constitué d'un super-réseau en GAlnAs/AllnAs ou GalnAsP/AlGalnAs.

12. Composant selon l'une des revendications 1 à 11, caractérisé par le fait que le second matériau (20) est constitué d'un matériau massif.

13. Composant selon l'une des revendications 1 à 12, caractérisé par le fait que le premier matériau (10) est une couche épitaxiale déposée au dessus du second matériau (20).

14. Composant selon l'une des revendications 1 à 12, caractérisé par le fait que le second matériau (20) est une couche épitaxiale déposée au dessus du premier matériau (10).

15. Composant selon la revendication 14, caractérisé par le fait que le second matériau (20) est au moins partiellement optiquement transparent à la longueur d'onde d'excitation.

16. Composant selon l'une des revendications 1 à 15, caractérisé par le fait qu'il comprend deux couches de contact (32, 44) qui sont des couches épitaxiales déposées de part et d'autre de la structure.

17. Composant selon l'une des revendications 1 à 16, caractérisé par le fait qu'il comprend au moins une couche graduelle intercalaire (34, 36, 38, 42).

18. Composant selon l'une des revendications 1 à 16, caractérisé par le fait qu'il comprend au moins une couche graduelle intercalaire (34, 36, 38, 42) constituée d'un super-réseau.

19. Composant selon l'une des revendications 1 à 18, caractérisé par le fait qu'il comprend en outre une couche optiquement transparente (40) intercalée entre une couche de contact (44) et l'un des deux matériaux (10, 20).

20. Composant selon l'une des revendications 1 à 19, caractérisé par le fait qu'il comprend une couche de contact (44) gravée partiellement en épaisseur, en regard d'une zone d'application de lumière.

21. Composant selon l'une des revendications 1 à 20, caractérisé par le fait qu'il comprend une couche de contact (32) rendue accessible par gravure des couches superposées (34, 20, 36, 10, 38, 40, 42, 44).

22. Composant selon l'une des revendications 1 à 21, caractérisé par le fait qu'il comprend les couches épitaxiales successives suivantes, sur un substrat (30) semi-isolant :
- une couche (32), dopé, servant à la prise de contact;
- une couche graduelle dopée (34);
- un super-réseau qui constitue le second matériau (20);
- une couche graduelle non dopée (36);
- une couche qui constitue le premier matériau (10);
- une couche graduelle dopée (38);
- une couche (40) formant "fenêtre" transparente à la longueur d'onde excitatrice;
- une couche graduelle dopée(42) et
- une couche (44) dopé.

23. Composant selon la revendication 22, caractérisé par le fait que le substrat (30) est dopé et qu'une couche dopée est déposée sur le substrat (30) avant dépôt des couches précitées.

24. Composant selon l'une des revendications 1 à 23, caractérisé par le fait qu'il comprend les couches épitaxiales successives suivantes, sur un substrat (30) en GaAs semi-isolant :
- une couche (32) de GaAs, dopé, servant à la prise de contact;
- une couche graduelle dopée (34), qui est constituée comme toutes les couches graduelles d'un super-réseau GaAs/AlAs de période variable;
- un super-réseau en GaAs/AlAs, non dopé, de 53 périodes de 14 monocouches de GaAs et de 6 monocouches de AlAs, qui constitue le second matériau (20);
- une couche graduelle non dopée (36);
- une couche massive de GaAs, non dopée, qui constitue le premier matériau (10);
- une couche graduelle dopée (38);
- une couche (40)formant "fenêtre" transparente à la longueur d'onde excitatrice, dopée, qui est constituée de 100 périodes d'un super-réseau GaAs/AlAs de respectivement 3 monocouches de GaAs et de 4 monocouches de AlAs;
- une couche graduelle dopée (42) et
- une couche (44) de GaAs dopé.

25. Composant selon l'une des revendications 1 à 24, caractérisé par le fait que le premier matériau (10) est en GaAs tandis que le second matériau (20) est formé de GaAlAs ou de AlAs ou d'un super-réseau en GaAs/AlAs ou GaAs/GaAlAs.

26. Composant selon l'une des revendications 1 à 24, caractérisé par le fait que le premier matériau (10) est en InGaAs et le second matériau (20) est constitué soit d'un matériau massif soit d'un super-réseau en InGaAs/InAlAs ou InGaAsP/InAlAsP.

27. Composant selon l'une des revendications 1 à 26, caractérisé par le fait que le second matériau (20) est constitué d'un super-réseau en GaInAs/AlInAs ou en matériaux quaternaires par exemple GaInAsP.

## Patentansprüche

1. Lichtgesteuerter Heterostruktur-Halbleiterbaustein zur Erzeugung von Mikrowellen, dadurch charakterisiert, daß die Heterostruktur zwei elektrisch leitende Kontakte (50, 52) und zwischen diesen mindestens zwei halbleitende Materialien umfaßt: eines (10), das mindestens durch Erzeugung von Elektron-Loch-Paaren optisch absorbierend ist und das andere (20), das für die durch die Kathode injizierten Majoritätsträger ein Geschwindigkeitsgesetz als Funktion des elektrischen Felds mit einem Bereich mit negativer Steigung aufweist.

2. Baustein nach Anspruch 1, dadurch charakterisiert, daß das erste Material (10) auch eine Zone darstellt, durch die die durch Licht erzeugten Minoritätsträger schnell durchgehen, die einen starken von der Kathode kommenden Hauptstrom induzieren.

3. Baustein nach einem der Ansprüche 1 oder 2, dadurch charakterisiert, daß das zweite Material (20) auch so ausgewählt wird, daß die Minoritätsträger dort langsamer sind als im ersten Material (10) oder daß die Heterobindung zwischen den Materialien (10-20) für die Minoritätsträger blockierend ist.

4. Baustein nach einem der Ansprüche 1 bis 3, dadurch charakterisiert, daß das erste Material (10) aus einer massiven Schicht aufgebaut ist.

5. Baustein nach einem der Ansprüche 1 bis 4, dadurch charakterisiert, daß das erste Material (10) aus einer ersten massiven Schicht aus GaAs aufgebaut ist.

6. Baustein nach einem der Ansprüche 1 bis 4, dadurch charakterisiert, daß das erste Material (10) aus einer massiven Schicht aus InₓGa₁₋ₓAs_{y}P_{1-y} oder In_{0,53}Ga_{0,47}As oder AlₓGa_{y}In_{1-x-y}As aufgebaut ist.

7. Baustein nach einem der Ansprüche 1 bis 3, dadurch charakterisiert, daß das erste Material (10) aus einem Übergitter aufgebaut ist.

8. Baustein nach Anspruch 7, dadurch charakterisiert, daß das erste Material (10) aus einem Übergitter aus GalnAs/AllnAs oder GalnAsP/AlGalnAs aufgebaut ist.

9. Baustein nach einem der Ansprüche 1 bis 8, dadurch charakterisiert, daß das zweite Material (20) aus einem Übergitter aufgebaut ist.

10. Baustein nach einem der Ansprüche 1 bis 7, dadurch charakterisiert, daß das zweite Material (20) aus einem Übergitter GaAs/AlAs aufgebaut ist.

11. Baustein nach einem der Ansprüche 1 bis 7, dadurch charakterisiert, daß das zweite Material (20) aus einem Übergitter aus GalnAs/AllnAs oder GalnAsP/AlGalnAs aufgebaut ist.

12. Baustein nach einem der Ansprüche 1 bis 11, dadurch charakterisiert, daß das zweite Material (20) aus einem massiven Material aufgebaut ist.

13. Baustein nach einem der Ansprüche 1 bis 12, dadurch charakterisiert, daß das erste Material (10) eine epitaxiale Schicht ist, die oberhalb des zweiten Materials (20) abgeschieden ist.

14. Baustein nach einem der Ansprüche 1 bis 12, dadurch charakterisiert, daß das zweite Material (20) eine expitaxiale Schicht ist, die oberhalb des ersten Materials (10) abgeschieden ist.

15. Baustein nach Anspruch 14, dadurch charakterisiert, daß das zweite Material (20) mindestens teilweise optisch transparent für die Anregungswellenlänge ist.

16. Baustein nach einem der Ansprüche 1 bis 15, dadurch charakterisiert, daß er zwei Kontaktschichten (32, 44), die epitaxiale Schichten sind und auf der einen und anderen Seite der Struktur abgeschieden sind, umfaßt.

17. Baustein nach einem der Ansprüche 1 bis 16, dadurch charakterisiert, daß er mindestens eine graduelle Zwischenschicht (34, 36, 38, 42) umfaßt.

18. Baustein nach einem der Ansprüche 1 bis 16, dadurch charakterisiert, daß er mindestens eine aus einem Übergitter gebildete graduelle Zwischenschicht (34, 36, 38, 42) umfaßt.

19. Baustein nach einem der Ansprüche 1 bis 18, dadurch charakterisiert, daß er darüber hinaus mindestens eine optisch transparente Schicht (40) umfaßt, die zwischen einer Kontaktschicht (44) und einem der Materialien (10, 20) angeordnet ist.

20. Baustein nach einem der Ansprüche 1 bis 19, dadurch charakterisiert, daß er mindestens eine Kontaktschicht (44) umfaßt, die unter Bezug auf eine Lichteinstrahlungszone teilweise in der Dicke eingeschnitten ist.

21. Baustein nach einem der Ansprüche 1 bis 20, dadurch charakterisiert, daß er mindestens eine Kontaktschicht (32) umfaßt, die durch Einschneiden der überlagerten Schichten (34, 20, 36, 10, 38, 40, 42, 44) zugänglich ist.

22. Baustein nach einem der Ansprüche 1 bis 21, dadurch charakterisiert, daß er die aufeinanderfolgenden epitaxialen nachfolgenden Schichten auf einem halbisolierenden Substrat (30) umfaßt:
- eine dotierte Schicht (32), die als Kontaktnehmer dient;
- eine graduelle dotierte Schicht (34);
- ein Übergitter, das das zweite Material (20) darstellt;
- eine graduelle nicht dotierte Schicht (36);
- eine Schicht, die das erste Material (10) darstellt;
- eine graduelle dotierte Schicht (38);
- eine Schicht (40), die ein transparentes Fenster für die Anregungswellenlänge bildet;
- eine graduelle dotierte Schicht (42), und
- eine dotierte Schicht (44).

23. Baustein nach Anspruch 20, dadurch charakterisiert, daß das Substrat (30) dotiert ist und daß eine dotierte Schicht vor der Abscheidung der vorstehend angegebenen Schichten auf dem Substrat (30) abgeschieden wird.

24. Baustein nach einem der Ansprüche 1 bis 23, dadurch charakterisiert, daß er die aufeinanderfolgenden epitaxialen folgenden Schichten auf einem halbisolierenden Substrat (30) aus GaAs umfaßt:
- eine Schicht (32) aus GaAs, dotiert, die als Kontaktnehmer dient;
- eine graduelle dotierte Schicht (34), die wie alle graduellen Schichten aus einem Übergitter GaAs/AlAs mit variabler Periode gebildet wird;
- ein Übergitter aus GaAs/AlAs, nicht dotiert, aus 53 Perioden von 14 Monoschichten aus GaAs und 6 Monoschichten aus AlAs, das das zweite Material (20) bildet;
- eine graduelle nicht dotierte Schicht (36);
- eine massive Schicht aus GaAs, nicht dotiert, die das erste Material (10) bildet;
- eine graduelle dotierte Schicht (38);
- eine Schicht (40), die ein für die Anregungswellenlänge transparentes Fenster bildet, die aus 100 Perioden eines Übergitters GaAs/AlAs mit jeweils 3 Monoschichten GaAs und 4 Monoschichten AlAs gebildet wird;
- eine graduelle dotierte Schicht (42) und
- eine Schicht (44) aus dotiertem GaAs.

25. Baustein nach einem der Ansprüche 1 bis 24, dadurch charakterisiert, daß das erste Material (10) aus GaAs besteht, während das zweite Material (20) aus GaAlAs oder aus AlAs oder aus einem Übergitter aus GaAs/AlAs oder GaAs/GaAlAs gebildet wird.

26. Baustein nach einem der Ansprüche 1 bis 24, dadurch charakterisiert, daß das erste Material (10) aus InGaAs besteht und das zweite Material (20) entweder aus einem massiven Material oder aus einem Übergitter aus InGaAs/InAlAs oder InGaAsP/InAlAsP gebildet wird.

27. Baustein nach einem der Ansprüche 1 bis 26, dadurch charakterisiert, daß das zweite Material (20) aus einem Übergitter aus GalnAs/AlINAs oder aus quaternären Materialien, beispielsweise GalnAsP gebildet wird.

## Claims

1. A light-controlled semiconductor heterostructure component for generating microwave frequency oscillations, characterized by the fact that the heterostructure comprises two electrically conductive contacts (50. 52) and at least two semiconductor materials therebetween: at least one of them (10) absorbing light by creating electron-hole pairs; and the other one of them (20) having majority carriers injected via the cathode with a relationship of velocity as a function of electric field that presents a region of negative slope.

2. A component according to claim 1, characterized by the fact that the first material (10) also constitutes a rapid transit zone for the photocreated minority carriers which induce a strong majority carrier current coming from the cathode.

3. A component according to claim 1 or 2, characterized by the fact that the second material (20) is also chosen so that the minority carriers therein are slower than in the first material (10) or so that the heterojunction between said materials (10. 20) blocks the minority carriers.

4. A component according to any one of claims 1 to 3, characterized by the fact that the first material (10) is constituted by a solid layer.

5. A component according to any one of claims 1 to 4, characterized by the fact that the first material (10) is constituted by a solid layer of GaAs.

6. A component according to any one of claims 1 to 4, characterized by the fact that the first material (10) is constituted by a solid layer of InₓGa₁₋ₓAs_{y}P_{1-y} or of In_{0.53}Ga_{0.47} As or of Alₓ Ga_{y} In_{1-x-y} As.

7. A component according to any one of claims 1 to 3, characterized by the fact that the first material (10) is constituted by a superlattice.

8. A component according to claim 7, characterized by the fact that the first material (10) is constituted by a superlattice of GaInAs/AlInAs or of GaInAsP/AlGaInAs.

9. A component according to any one of claims 1 to 8, characterized by the fact that the second material (20) is constituted by a superlattice.

10. A component according to any one of claims 1 to 7, characterized by the fact that the second material (20) is constituted by a GaAs/AlAs superlattice.

11. A component according to any one of claims 1 to 7, characterized by the fact that the second material (20) is constituted by a superlattice of GaInAs/AlInAs or of GaInAsP/AlGaInAs.

12. A component according to any one of claims 1 to 11, characterized by the fact that the second material (20) is constituted by a solid material.

13. A component according to any one of claims 1 to 12, characterized by the fact that the first material (10) is an epitaxial layer deposited on the second material (20).

14. A component according to any one of claims 1 to 12, characterized by the fact that the second material (20) is an epitaxial layer deposited on the first material (10).

15. A component according to claim 14, characterized by the fact that the second material (20) is at least partially optically transparent at the excitation wavelength.

16. A component according to any one of claims 1 to 15, characterized by the fact that it includes two contact layers (32, 44) which are epitaxial layers deposited on either side of the structure.

17. A component according to any one of claims 1 to 16, characterized by the fact that it includes at least one interposed graded layer (34, 36, 38, 42).

18. A component according to any one of claims to 16, characterized by the fact that it includes at least one interposed graded layer (34. 36. 38. 42) constituted by a superlattice.

19. A component according to any one of claims 1 to 18, characterized by the fact that it further includes an optically transparent layer (40) interposed between a contact layer (44) and one of the two materials (10, 20).

20. A component according to any one of claims 1 to 19, characterized by the fact that it comprises a contact layer (44) that has its thickness etched in part over the zone for application of light.

21. A component according to any one of claims 1 to 20, characterized by the fact that it includes a contact layer (32) that is made accessible by etching layers superposed thereon (34, 20, 36, 10, 38, 40, 42, 44).

22. A component according to any one of claims 1 to 21, characterized by the fact that it comprises the following successive epitaxial layers on a semi-insulating substrate (30):
a doped layer (32) serving to make electrical contact;
a doped graded layer (34);
a superlattice constituting the second material (20);
a non-doped graded layer (36);
a layer constituting the first material (10);
a doped graded layer (38);
a window-forming layer (40) that is transparent at the exciting wavelength;
a doped graded layer (42); and
a doped layer (44).

23. A component according to claim 22, characterized by the fact that the substrate (30) is doped and that a doped layer is deposited on the substrate (30) prior to depositing the above-specified layers.

24. A component according to any one of claims 1 to 23, characterized by the fact that it comprises the following successive epitaxial layers on a semi-insulating GaAs substrate (30):
a doped GaAs layer (32) for making electrical contact;
a doped graded layer (34) which is constituted, as are all the graded layers, by a GaAs/AlAs superlattice of varying period;
a non-doped GaAs/AlAs superlattice comprising 53 periods of 14 GaAs monolayers and of 6 AlAs monolayers, constituting the second material (20);
a non-doped graded layer (36);
a non-doped GaAs solid layer constituting the first material (10);
a doped graded layer (38);
a doped window-forming layer (40) that is transparent at the exciting wavelength and that is constituted by 100 periods of a GaAs/AlAs superlattice each having three GaAs monolayers and 4 AlAs monolayers;
a doped graded layer (42); and
a doped GaAs layer (44).

25. A component according to any one of claims 1 to 24, characterized by the fact that the first material (10) is made of GaAs while the second material (20) is made of GaAlAs or of AlAs or of a superlattice of GaAs/AlAs or of GaAs/GaAlAs.

26. A component according to any one of claims 1 to 24, characterized by the fact that the first material (10) is made of InGaAs, and the second material (20) is constituted either by a solid material or else by a superlattice of InGaAs/InAlAs or of InGaAsP/InAlAsP.

27. A component according to any one of claims 1 to 26, characterized by the fact that the second material (20) is constituted by a superlattice of GaInAs/AlInAs or of quaternary materials, e.g. GaInAsP.
